# EUROPEAN PATENT APPLICATION

(11) **EP 2 264 227 A1**
(43) Date of publication of application: **22.12.2010**
(21) Application number: 09728982.1
(22) Date of filing: 24.03.2009
(51) Int. Cl.: C30B 29/16, C30B 7/10

(54) **ZINC OXIDE SINGLE CRYSTAL AND METHOD FOR PRODUCING THE SAME**

(30) Priority: 04.04.2008 JP 2008097825; 01.08.2008 JP 2008199126; 23.03.2009 JP 2009069280
(71) Applicant: Fukuda Crystal Laboratory, Sendai-shi, Miyagi 989-3204 (JP); Tokyo Denpa Co., Ltd., Ota-ku Tokyo 143-0024 (JP); Mitsubishi Chemical Corporation, Minato-ku Tokyo 108-0014 (JP)
(72) Inventor: MIKAWA, Yutaka, Ushiku-shi Ibaraki 300-1295 (JP); FUKUTOMI, Keiji, Sendai-shi Miyagi 989-3204 (JP); SUZUKI, Takao, Tokyo 143-0024 (JP); ITOH, Hirohisa, Ushiku-shi Ibaraki 300-1295 (JP)
(74) Representative: Vossius & Partner
(86) International application number: PCT/JP2009/055870
(87) International publication number: WO 2009/122974

(57) **Abstract**

To produce a zinc oxide single crystal having a sufficiently low lithium concentration and a high crystallinity. A zinc oxide crystal is grown by hydrothermal synthesis method using a solution having a lithium concentration of 1 ppm or less (weight basis), while suppressing a fluctuation range of crystal growth temperature within 5°C or at a temperature within the range of 300 to 370°C.

## Description

### Technical Field

The present invention relates to a high quality zinc oxide single crystal utilizable in semiconductor devices and a method for producing the same. More specifically, the invention relates to a zinc oxide single crystal having a low lithium concentration and a characteristic method for producing the same.

### Background Art

A zinc oxide single crystal is a semiconductor having a crystalline structure of a hexagonal wurtzite compound and a large forbidden band width upon direct transition (Eg: 3.37eV). Since it has an extremely high exciton binding energy (ZnO: 60 meV) when compared with other semiconductor materials (GaN: 21 meV, ZnSe: 20 meV), it is expected to serve as a highly efficient light-emitting device material. While zinc oxide should be prepared as a p type for realizing a light-emitting device utilizing zinc oxide, zinc oxide tends to become an n type and is difficult naturally to become a p type because of a tendency of undergoing defects such as an oxygen deficiency or interstitial zinc.

Currently, a large number of research institutes are studying the conversion of zinc oxide into a p type, which is expected, if realized, to result in a revolution in the fields of photoelectronics and energy. Also, since its crystalline structure is the same as that of a gallium nitride which has actually been utilized for several years as a blue light-emitting diode (LED) and lattice constant is also close to that of gallium nitride (lattice mismatch: about 2%) and also since it is possible to be produced in future at a low cost, it is focused on also as a gallium nitride film forming substrate as a substitute for sapphire or carbon carbide which has been mainly employed for the substrate in these days.

In addition, a zinc oxide single crystal has been employed in many fields including surface acoustic wave (SAW), gas sensor, piezoelectric device, transparent electroconductive body, varistor and the like.

As a growth method of a zinc oxide single crystal, a growth method by hydrothermal synthesis method is known. The hydrothermal synthesis method is a method of growing a crystal in an aqueous raw material solution at a high temperature under a high pressure and a method of precipitating a crystal on a crystal seed utilizing a supersaturation degree induced by a temperature difference. Since the hydrothermal synthesis method is suitable for mass production by using a large pressure chamber, the hydrothermal synthesis method has been widely used as a growth method of a quartz single crystal since a long time ago. However, since solubility of a quartz raw material is extremely low in water in a high-temperature and high-pressure state, it is difficult to obtain a practical growth rate. Therefore, a mineralizer is added in order to increase the solubility of the raw material and improve the crystal growth rate. In the growth of quartz, NaOH or Na₂CO₃ is employed as the mineralizer and the concentration is about 1 mol/l in both cases. Also in the case of growing a zinc oxide single crystal, a growth experiment was performed with an aqueous NaOH solution having a concentration of 1 to 2 mol/l similarly to the case of quartz (see Non-Patent Reference 1). However, when a crystal is grown on C plane ((0001) plane) of a crystal seed, a crevasse-like macro defect called flowing or crevasse flow appears, so that a single crystal worth evaluating has not yet been obtained.

In order to suppress flowing occurring at such crystal growth on the C plane, it has been proposed to add lithium into an aqueous solution of zinc oxide (see Non-Patent Reference 2). An effective amount is considered to be a concentration of about 0.1 to 2 mol/l as LiOH and the flowing-suppressing effect is considered to disappear when the amount is 0.1 mol/l or less. Moreover, it is reported that an equal effect is obtained using LiF, Li₂B₄O₇, or the like other than LiOH (see Patent Reference 1). Detailed investigation results have been reported about the mechanism of suppressing the flowing on the C plane by such addition of lithium (see Non-Patent Reference 1).

In the zinc oxide single crystals grown by these methods including addition of lithium, lithium is unavoidably contained. In the case where a zinc oxide single crystal is used as a piezoelectric material, the incorporation of lithium is not problematic and contrarily, studies of adding lithium have been actively performed since the incorporation of lithium improves resistivity with acting as an acceptor (see Non-Patent Reference 3). However, in the application as a currently expected single crystal substrate for light-emitting devices, since lithium has an adverse effect on devices, it is required to reduce it thoroughly. This is because, when epitaxial growth is performed on a zinc oxide single crystal substrate containing a considerable amount of lithium, the lithium in the single crystal substrate diffuses into the epitaxial film, so that objective characteristics are not obtained. Since lithium acts as a donor or an acceptor in zinc oxide and has an adverse effect on semiconductor characteristics, it is desired to suppress the content as far as possible.

However, hitherto, a zinc oxide single crystal having a high crystallinity cannot be obtained unless the methods including addition of lithium is employed, so that a considerable amount (1×10¹⁷ to 1×10¹⁹ atoms/cm³) of lithium is unavoidably contained in the zinc oxide single crystal. Therefore, as a method for reducing lithium, there has been proposed a method of removing lithium from a grown zinc oxide single crystal by a heat treatment or the like. For example, Patent Reference 2 describes a method of lowering the lithium concentration to 3×10¹⁶ atoms/cm³ by subjecting a zinc oxide wafer to a heat treatment and Patent Reference 3 describes a method of lowering the lithium concentration to 1×10¹⁵ atoms/cm³ by subjecting a grown crystal to a heat treatment.

Patent Reference 1: A.J. Caporaso, E.D. Kolb, R.A. Laudise, US Patent No. 3,201,209 (1965₎
Patent Reference 2: JP-A-2007-1787
Patent Reference 3: JP-A-2007-204324
Non-patent Reference 1: R.A. Laudise and A.A. Ballman, "Hydrothermal synthesis method of Zinc Oxide and Zinc Sulfide", Journal of Physical Chemistry, vol. 64, pp688-691 (1960)
Non-patent Reference 2: R.A. Laudise, E.D. Kolb and A.J. Caporaso, "Hydrothermal Growth of Large Sound Crystals of Zinc Oxide", Journal of The American Ceramic Society, vol.47, pp9-12 (1964)
Non-patent Reference 3: E.D. Kolb and R.A. Laudise, "Properties of Lithium-Doped Hydrothermally Grown Single Crystals of Zinc Oxide", Journal of The American Ceramic Society, vol.48, No.7, pp342-345 (1965)

### Disclosure of the Invention

### Problems that the Invention is to Solve

However, both of the heat treatment methods described in the above Patent References 2 and 3 are methods devised base on the presupposition that the inclusion of lithium in the crystals grown by the hydrothermal synthesis method is unavoidable in terms of the producing methods. As post-processes such as the heat treatment increase, factors of cost rising such as decrease in the yield ratio and extended unevenness of the quality increase. Furthermore, in the heat treatment step, there is a concern of an increase in uncertain factors such as induction of a new point defect in a zinc oxide single crystal. From the viewpoint of industrial technology or from the viewpoint of reducing energy consumption required for the production, a zinc oxide single crystal requiring no such post-processes is desired.

Accordingly, the present inventors have considered that the development of a growth technology of a zinc oxide single crystal having a sufficiently low lithium concentration may result in simplification of the processes, improvement in the production yield ratio, stabilization of the quality, and cost reduction and also contributes to a dramatic improvement in the performance of semiconductor devices using zinc oxide. In order to solve the above problems of the background art, the inventors have further investigated, as an object of the invention, the production of a zinc oxide single crystal having a sufficiently low lithium concentration and a high crystallinity by a simple and convenient method.

### Means for Solving the Problems

As a result of the extensive studies for solving the above problems, the present inventors have found that a high quality zinc oxide single crystal where defects such as flowing are suppressed can be provided by subjecting zinc oxide to crystal growth under specific conditions without adding lithium and thus have accomplished the invention. Namely, as a method for solving the problems, the following invention is provided.

[1] A zinc oxide single crystal whose lithium concentration in the crystal is 5×10¹⁴ atoms/cm³ or less.
[2] The zinc oxide single crystal according to [1], wherein a half width determined by X-ray locking curve measurement in (0002) plane reflection is 50 seconds or less.
[3] The zinc oxide single crystal according to [1] or [2], wherein the principal plane is C plane, M plane, R plane, Rp plane, or Rn plane.
[4] The zinc oxide single crystal according to any one of [1] to [3], wherein the nitrogen content in the crystal is 1×10¹⁸ atoms/cm³ or less.
[5] The zinc oxide single crystal according to any one of [1] to [4], wherein the aluminum concentration in the crystal is 2×10¹⁴ atoms/cm³ or less.
[6] The zinc oxide single crystal according to any one of [1] to [5], wherein the major diameter is 15 mm or more.
[7] The zinc oxide single crystal according to any one of [1] to [6], wherein the carrier concentration at room temperature is 1×10¹⁴ to 1×10¹⁸ atoms/cm³.
[8] The zinc oxide single crystal according to any one of [1] to [7], wherein the mobility at room temperature is more than 100 cm²/V·sec and 300 cm²/V·sec or less.
[9] The zinc oxide single crystal according to any one of [1] to [8], wherein the specific resistance is 1×10⁻³ to 1×10³ (Ω·cm).
[10] The zinc oxide single crystal according to any one of [1] to [9], wherein the crystal contains one kind or two or more kinds of trivalent metal elements and the content is 1×10¹⁶ to 1×10²⁰ atoms/cm³.
[11] The zinc oxide single crystal according to any one of [1] to [10], which is produced by hydrothermal synthesis method.

[12] A method for producing a zinc oxide single crystal which comprises growing a zinc oxide crystal by hydrothermal synthesis method using a solution having a lithium concentration of 1 ppm or less (weight basis) at a temperature within the range of 300 to 370°C.
[13] A method for producing a zinc oxide single crystal which comprises growing a zinc oxide crystal using a solution having a lithium concentration of 1 ppm or less (weight basis) while suppressing a fluctuation range of crystal growth temperature within 5°C at the growth of the zinc oxide crystal by hydrothermal synthesis method.
[14] The method for producing a zinc oxide single crystal according to [12] or [13], wherein the solution does not contain lithium.
[15] The method for producing a zinc oxide single crystal according to any one of [12] to [14], wherein the solution does not contain an ammonium ion.
[16] The method for producing a zinc oxide single crystal according to any one of [12] to [15], wherein a raw material having a lithium concentration of 0.1 ppm or less (weight basis) is employed.
[17] The method for producing a zinc oxide single crystal according to any one of [12] to [16], wherein a zinc oxide crystal is grown in a reaction container having an inner wall that uses an alloy containing platinum and one kind or more of elements of the platinum group other than platinum.
[18] The method for producing a zinc oxide single crystal according to [17], wherein an alloy containing 5 to 30% by weight of the elements of the platinum group other than platinum is employed.
[19] The method for producing a zinc oxide single crystal according to [17] or [18], wherein the element of the platinum group other than platinum is iridium.
[20] The method for producing a zinc oxide single crystal according to any one of [12] to [19], wherein a zinc oxide crystal is grown in a reaction container having a pressure-buffering mechanism provided in a raw material-dissolution region.
[21] A zinc oxide single crystal produced by the producing method according to any one of [12] to [20].

### Advantage of the Invention

The zinc oxide single crystal of the invention has a sufficiently low lithium concentration and has a high crystallinity. Also, according to the producing method of the invention, such a zinc oxide single crystal can be stably and conventionally produced in a high yield ratio.

### Brief Description of the Drawings

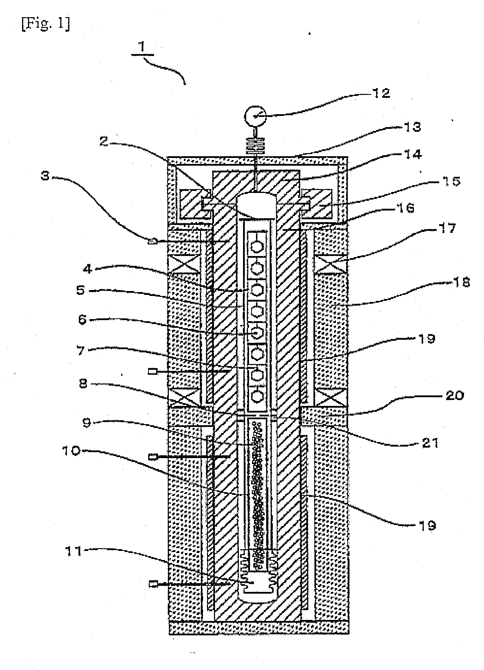

[Fig. 1] Fig. 1 is a schematic cross-sectional view showing one example of a crystal growth apparatus for producing the zinc oxide single crystal of the invention.

### Description of Reference Numerals and Signs

- 1: crystal growth apparatus
- 2: inner cylinder cap
- 3: thermocouple
- 4: growth frame
- 5: inner cylinder
- 6: crystal seed
- 7: wire
- 8: baffle
- 9: raw material
- 10: raw material cage
- 11: bellows
- 12: pressure gauge
- 13: upper heat retainer
- 14: autoclave cap
- 15: clamp
- 16: main body of autoclave
- 17: window
- 18: heat retainer
- 19: heater
- 20: heat retainer partition
- 21: external baffle

### Best Mode for Carrying Out the Invention

The following will explain the zinc oxide single crystal of the present invention and a method for producing the same in detail. The explanation of constituents described in the following may be sometimes done based on representative embodiments of the invention but the invention is not limited to such embodiments. Incidentally, in the present Description, the range of a numeral represented using "to" means a range including the numerals described before and after the "to" as a lower limit and an upper limit.

### (Zinc Oxide Single Crystal)

The zinc oxide single crystal of the invention is **characterized in that** the lithium concentration in the crystal is 5×10¹⁴ atoms/cm³ or less. The lithium concentration in the crystal in the invention can be measured by secondary ion mass spectrometry. The lithium concentration in the zinc oxide single crystal of the invention is 5×10¹⁴ atoms/cm³ or less, preferably 1×10¹⁴ atoms/cm³ or less, and further preferably 5×10¹³ atoms/cm³ or less.

Moreover, the zinc oxide single crystal of the invention has a high crystallinity. Specifically, a half width determined by X-ray locking curve measurement in (0002) plane reflection is preferably 50 seconds or less, more preferably 30 seconds or less, further preferably 25 seconds or less, and particularly preferably 20 seconds or less. A zinc oxide single crystal having a low lithium concentration and a high crystallinity cannot be produced by any conventional technologies and is first provided by the producing method of the invention to be mentioned below.

Furthermore, the principal plane of the zinc oxide single crystal herein is referred to a plane having the largest area in the grown zinc oxide single crystal. The principal plane of the zinc oxide single crystal may be any plane constituting the zinc oxide single crystal but is preferably C plane, M plane, R plane, Rp plane, or Rn plane, more preferably C plane.
Incidentally, in the present Description, the C plane is referred to (0001) plane and (000-1) plane in a hexagonal crystal. Moreover, in the present application, the M plane is referred to (1-100) plane and an equivalent plane thereto in a hexagonal crystal, is a non-polar plane, and is usually a cleavage plane. Specifically, there are (1-100) plane, (-1100) plane, (01-10) plane, (0-110) plane, (10-10) plane, and (-1010) plane and any plane is possible. In the application, the R plane is referred to (1-101) plane, (1-10-1) plane and an equivalent plane thereto in a hexagonal crystal, the Rp plane is referred to (1-102) plane and an equivalent plane thereto, and the Rn plane is referred to (2-20-1) plane and an equivalent plane thereto. In the present application, the A plane is referred to (11-20) plane and an equivalent plane thereto in a hexagonal crystal. Moreover, the normal line directions of the C plane, the M plane, and the A plane are referred to as a c axis, an m axis, and an a axis, respectively.

The zinc oxide single crystal of the invention preferably has also a low concentration of impurities other than lithium.
For example, the nitrogen content in the zinc oxide single crystal of the invention is preferably 1×10¹⁸ atoms/cm³ or less, more preferably 5×10¹⁷ atoms/cm³ or less, and further preferably 1×10¹⁷ atoms/cm³ or less. For example, in the conventional method for producing a zinc oxide single crystal using an ammonium ion as described in JP-A-6-289192, the nitrogen content of such a low concentration cannot be realized.

Moreover, the aluminum concentration in the zinc oxide single crystal of the invention can be 2×10¹⁴ atoms/cm³ or less and is preferably 8×10¹³ atoms/cm³ or less and more preferably 5×10¹³ atoms/cm³ or less. The aluminum concentration herein can be measured by secondary ion mass spectrometry. Furthermore, the concentration of a metal other than aluminum contained in the zinc oxide single crystal of the invention preferably falls within the same concentration range as the preferable range of the above aluminum concentration. As the metal other than aluminum, there may be, for example, mentioned sodium, potassium, chromium, nickel, and titanium.

On the other hand, in order to control electric conductivity, it is also preferred that the zinc oxide single crystal of the invention may be incorporated with one kind or two or more kinds of trivalent metal elements (Al, Ga, In) and the content is 1×10¹⁶ to 1×10²⁰ atoms/cm³. A zinc oxide single crystal fulfilling such a condition has an improved electroconductivity and has an advantage that it is usable as a conductive substrate. The content of the trivalent metal element(s) is more preferably 1×10¹⁷ to 1×10²⁰ atoms/cm³ and further preferably 1×10¹⁸ to 1×10²⁰ atoms/cm³.
The adjustment of the above metal element concentration can be, for example, performed by adjusting the amount of metal oxide(s) to be added into a raw material. Since the zinc oxide single crystal of the invention has a small content of unintended impurities including lithium, control of characteristics by the addition (doping) of intended impurities can be achieved with good accuracy as compared with conventional zinc oxide single crystals.

In the zinc oxide single crystal of the invention, the major diameter is preferably 15 mm or more, more preferably 20 mm or more, and further preferably 25 mm or more. The major diameter herein means the longest diameter of the zinc oxide single crystal. According to the invention, there can be provided a zinc oxide single crystal having an unprecedented large size and an excellent crystallinity.

In the zinc oxide single crystal of the invention, the carrier concentration at room temperature is preferably 1×10¹⁴ to 1×10¹⁸/cm², more preferably 1×10¹⁵ to 1×10¹⁸/cm², further preferably 1×10¹⁵ to 1×10¹⁷/cm², and particularly preferably 1×10¹⁵ to 1×10¹⁶/cm².

In the zinc oxide single crystal of the invention, the mobility at room temperature is usually more than 100 cm²/V·sec and 300 cm²/V·sec or less and is preferably 120 to 300 cm²/V·sec and more preferably 150 to 300 cm²/V·sec. The mobility can be measured by hole measurement. Incidentally, the mobility herein is the mobility of an undoped crystal.

Moreover, in the zinc oxide single crystal of the invention, the specific resistance is usually 1×10⁻³ to 1×10³ (Ω·cm), preferably 1×10⁻² to 1×10³ (Ω·cm), and more preferably 1×10⁻¹ to 1×10³ (Ω·cm). The specific resistance herein is also specific resistance of an undoped crystal.

In the zinc oxide single crystal of the invention, a decrease in resistivity can be pursued by adding aluminum, gallium, or indium, more preferably gallium or indium. The concentration of the additive in the zinc oxide is preferably 1×10¹⁶ to 1×10²⁰ atoms/cm³, more preferably 1×10¹⁷ to 1×10²⁰ atoms/cm³, and further preferably 1×10¹⁸ to 1×10²⁰ atoms/cm³.

The zinc oxide single crystal of the invention has an advantage that the decrease in resistance of the single crystal can be pursued in the case of n type semiconductor owing to the low lithium concentration and high crystallinity as mentioned above. Moreover, since the concentration of impurities including lithium is sufficiently low, functional advancement such as an improvement in the mobility can be pursued. Furthermore, in the case where a semiconductor device is made using the highly pure zinc oxide single crystal of the invention as a substrate, an adverse effect on the semiconductor device induced by the diffusion of lithium can be suppressed to result in a remarkable increase in the device performance.

The method for producing a zinc oxide single crystal of the invention having the above characteristics is not particularly limited. A zinc oxide single crystal falls under the category of the zinc oxide single crystal of the invention as far as it fulfills the requirement defined in the above Claims, regardless of the producing method. The following will explain the crystal growth apparatus, crystal seed, and crystal growth process to be used in the preferred producing method of the zinc oxide single crystal of the invention with reference to Drawings.

### (Crystal Growth Apparatus)

The zinc oxide single crystal of the invention can be produced by hydrothermal synthesis method. A preferred crystal growth apparatus will be described with reference to Fig. 1.
In a preferred hydrothermal synthesis method, a high-strength steel-made pressure chamber (hereinafter referred to as an autoclave) is employed. The autoclave has a thick cylindrical form that is long in the vertical direction, and is composed of a main body 16 and a cap 14. The autoclave is placed in a heating furnace. The heating furnace is composed of a heat retainer 18 and a heater 19, and a partition 20 is provided at a middle part so that a sufficient temperature difference can be attained between an upper part and a lower part. The temperature is monitored by a thermocouple 3 and is controlled by a temperature-controlling apparatus. The pressure is measured by a pressure gauge 12. Since the upper half from the partition 20 of the heating furnace is a cooling zone, a plurality of windows 17 for cooling are provided on the heat retainer 18 and it is possible to precisely control the temperature by the degree of opening the windows 17.

A chamber 5 (hereinafter referred to as an "inner cylinder") made of an anticorrosive material is placed inside the main body of the autoclave. The material of the inner cylinder 5 is not limited as far as it is a material excellent in an anticorrosive property against an aqueous alkali solution but platinum has generally been considered to be preferable. However, since platinum is soft and is easily deformed, it also has a problem for controlling the growth conditions with high accuracy. Thus, in order to increase the strength of platinum and suppress the deformation, it is preferred to make the inner cylinder with selecting an alloy of platinum and an element of the platinum group. Hitherto, there has been no studies and reports on corrosion of an alloy of platinum and an element of the platinum group in a subcritical to supercritical aqueous alkaline solution but, as a result of extensive anticorrosion experiments performed by the inventors, an anticorrosive property equal to or higher than that of platinum is confirmed and thus it is found that the alloy is suitable as a material of the inner cylinder for crystal growth by hydrothermal synthesis method. The content of the element of the platinum group is preferably about 5 to 30% by weight, further preferably 10 to 20% by weight in view of easiness of processing. As the element of the platinum group, there may be mentioned one kind or two or more kinds of ruthenium, rhodium, palladium, and osmium and, particularly, iridium is preferred.

In order to prevent the inner cylinder 5 from being deformed or damaged by the difference between inner pressure and outer pressure of the inner cylinder 5, it is preferred to provide a pressure-buffering mechanism (e.g., a bellows structure 11) for diminishing the pressure difference with easy deformation. Since a solubility curve is positive (solubility increases as temperature is elevated) under the growth environment of the zinc oxide single crystal, the upper part of the inner cylinder is a growth region and the lower part of the inner cylinder is a raw material region. Therefore, when a conventional type of the apparatus where a cap part of the upper part of the inner cylinder is a bellows structure is employed, the uppermost part of the inner cylinder is easily cooled, so that microcrystals derived from spontaneous nucleus generation attach onto the inner surface of the bellows and the expansion and contraction of the bellows are inhibited. Since the decrease in the function of absorbing the difference between the inner pressure and the outer pressure owing to the microcrystal precipitation breaks down the pressure balance and may lead to the deformation and damage of the inner cylinder, it is particularly preferred to grow a crystal using an apparatus having a bellows provided on the bottom part of the inner cylinder in the invention. The lower part of the inner cylinder is a raw material region and is a region where crystals are dissolved, so that the precipitation of macrocrystals does not occur in the raw material region and the function of the bellows is not impaired.

With regard to the inner cylinder 5 itself, it is necessary to increase the strength and impart a high durability by making it out of a platinum iridium alloy but the bellows 11 should be easily deformed for absorbing the pressure difference between the outside and the inside of the inner cylinder. Thus, as a material of the bellows 11, it is preferred to use platinum. The material of the bellows 11 may be a material other than platinum as far as it is lower in hardness than the material of the inner cylinder 5 and has a sufficient anticorrosive property, and gold, silver, or an alloy thereof may be employed. For the cap 2 of the inner cylinder, any material of platinum and a platinum iridium alloy may be used and the shape is not limited. A method of fixing the bellows 11 and the inner cylinder 5 or the cap 2 and the inner cylinder 5 may be a method of fixing by welding, a mechanical fixing such as a clamp structure, or the like and the fixing method is not limited. Moreover, the inner cylinder 5 and the bellows 11 may be made as an integrated structure or may be made as a divided structure.

An external baffle 21 is provided outside the inner cylinder 5. The external baffle 21 plays a role of realizing a necessary temperature difference between the upper and lower parts of the solution infused into the outside of the inner cylinder 5. Since the material of the external baffle 21 is usually a metal (carbon steel, stainless steel alloy, nickel-based alloy, or the like), thermal conductivity is high and a large temperature difference is difficult to realize, so that the material becomes a factor of lowering the accuracy of temperature control. Therefore, more accurate control of the temperature difference can be enabled by providing two or more external baffles 21 and suppressing heat conduction by the external baffle 21 with allowing an aqueous solution to exist between the external baffles 21.

A baffle 8 is provided at the middle part of the inside of the inner cylinder 5 and, across the baffle, the upper part is a growth region and the lower part is a raw material region. The material of the baffle 8 may be any of platinum and a platinum iridium alloy. In the growth region, a crystal seed 6 cut out from the zinc oxide single crystal and a growth frame 4 for holding the crystal seed 6 are provided. In the raw material region, a raw material 9 and a raw material cage 10 into which the raw material is packed are provided. With regard to the growth frame 4 and the raw material cage 10, since strength for supporting crystals and the raw material is necessary, the use of a platinum iridium alloy is preferred similarly to the inner cylinder 5. The platinum iridium alloy preferably has an iridium content of about 5 to 30% by weight similarly to the material of the inner cylinder 5.

### (Crystal Seed)

In a preferred method for producing a zinc oxide single crystal of the invention, the zinc oxide single crystal is grown on a crystal seed.
As the crystal seed, it is particularly preferred to use a plate-like zinc oxide single crystal cut parallel to (0001) plane that is the C plane. A tilt from the C plane is preferably within 0.5°. The thickness is usually 0.5 to 2.0 mm and preferably 0.8 to 1.2 mm. The case where the thickness is 0.5 mm or more is preferred since a risk of dissolution during temperature elevation is low. The case where the thickness is 2.0 mm or less is advantageous in view of productivity since cost of the crystal seed is not exceedingly high. In this regard, a high quality crystal can be grown even when a crystal seed of the M plane that is a nonpolar plane or the R plane, Rp plane, or Rn plane that is a semipolar plane is used.

Since the production of the crystal seed is performed by a mechanical processing such as cutting or lapping, a processed altered layer is introduced onto the surface of the crystal seed with the progress thereof. The processed altered layer introduced into the crystal seed by the mechanical processing has been preferably removed by chemical etching. As a solution for use in the etching, an acid (preferably HCl, HNO₃, H₂SO₄, H₃PO₄), an alkali (preferably LiOH, NaOH, KOH, RbOH, CsOH), a mixed acid, or a mixed alkali solution can be used. The removal of the processed altered layer can be confirmed by observation on an optical microscope. In the case where the surface is finished by mechanochemical polishing or the like, the chemical etching can be omitted or the processed altered layer can be removed by etching for an extremely short period of time.

Since dislocation density in a crystal seed becomes a factor of determining dislocation density in a crystal to be grown, in order to grow a crystal having a low dislocation density, it is desirable to use a crystal seed having a low dislocation density. When the crystal seed having a low dislocation density is used, macro defects such as flowing are difficult to introduce to the C plane of the grown crystal. In the invention, etch pits are allowed to appear by the above chemical etching, etch pit density is measured on an optical microscope, and it is preferred to select and use a crystal seed having an etch pit density of 1×10⁴ pieces/cm² or less.

### (Production Process)

The following will describe a method of growing the highly pure zinc oxide single crystal of the invention using the above crystal growth apparatus.
Hydrothermal synthesis method is a method of dissolving a raw material in a subcritical to supercritical aqueous solution and growing a crystal through recrystallization of the dissolved raw material. In the invention, an aqueous solution having a lithium concentration of 1 ppm (weight basis) or less is employed. Preferably, an aqueous solution containing only KOH is used without adding lithium. It is a main target not to contain lithium, so that NaOH can be also used instead of KOH. Hitherto, in the hydrothermal synthesis method, it is recognized that it is impossible to grow a defect-free high quality zinc oxide single crystal in the case where lithium is not added but, from observation of morphology of a zinc oxide single crystal grown without adding lithium, it is found that causes of generation of macro defects such as flowing on the C plane lie on change and fluctuation of conditions in the crystal growth environments, such as insufficient feed of the raw material, partial stagnation of convection, and change in temperature. When lithium is added, the growth in the vertical direction to the c axis, i.e., in the direction of the a axis or the m axis can be promoted, so that the occurrence of flowing can be inhibited but the inventors have found that it is possible to suppress the factors for generating flowing by optimization of the growth conditions without adding lithium.

A hole having a diameter of 0.3 to 0.5 mm is made on the crystal seed, a platinum wire is allowed to pass through the hole, and the crystal seed is fixed to the growth frame. In order not to inhibit convection of the solution, it is preferred to fix it so that the widest surface of the crystal seed becomes almost parallel to the vertical direction. The "almost parallel" herein means that the angle falls within 180°±30°. By adopting such a fixing method, not only is the convection smoothly realized but also deposition and firm adhesion of the microcrystals on the crystal seed can be effectively reduced. This is because the microcrystals tend to precipitate and deposit by gravitation.

As the raw material, there is employed a zinc oxide sintered form obtained by molding a zinc oxide powder having a diameter of 1 to 10 µm using a pressure press and sintering the molded one in an oxygen atmosphere or an air atmosphere at 1000 to 1400°C. With regard to the purity of the raw material, it is preferred to use a raw material having a purity of 99.999% or more. The lithium concentration in the raw material is preferably 0.1 ppm (weight basis) or less and more preferably 0.05 ppm or less. With regard to the size of the raw material, an optimum value varies depending on the size of the autoclave to be used but the major diameter is preferably 5 mm to 50 mm. When the raw materials different in size are mixed, the amount packed into the raw material cage increases, so that the mixing is effective in the case where a large amount of the raw material is packed.

The baffle to be provided in the inner cylinder preferably has an opening ratio of 5 to 15% and the baffle having one hole at the central part or plurality of holes in an axially symmetric manner. It is preferred to have a gap between the outer periphery of the baffle and the inner wall of the inner cylinder. The baffle opening ratio is obtained by dividing the sum of the area of the hole made in the baffle and the area of the gap between the outer periphery of the baffle and the inner wall of the inner cylinder by the cross-sectional area of the inside of the inner cylinder. With regard to the number of the baffle, one sheet of baffle has a sufficient effect but it is possible to attain the temperature difference more easily by using two or more sheets of the baffle.

Into the inside of the inner cylinder, it is preferred to infuse, for example, a 3 to 6 mol/l KOH solution in an infusing ratio of 80 to 95%. The concentration of lithium contained in the KOH solution is 1 ppm (weight basis) or less and further preferably 0.1 ppm or less.

Into the outside of the inner cylinder, a solution is infused in an infusing ratio of 75 to 85% in order to keep a pressure balance with the inside of the inner cylinder and further to attain heat conduction. The kind of the solution is suitably pure water in consideration of no corrosion of the autoclave. Depending on the material of the autoclave, the corrosion can be further suppressed by using a dilute alkali solution. As the dilute alkali solution, 0.005 to 0.1 mol/l NaOH can be employed. Other than NaOH, an alkali such as KOH, Na₂CO₃, or K₂CO₃ can be also used.

After being capped and tightly sealed, the autoclave is heated by an external heater. The temperature is elevated so as to reach a running condition temperature from room temperature over a period of 30 to 72 hours. During the temperature elevation, since the solution is not yet saturated, both of the raw material and the crystal seed are dissolved. The temperature-elevating process is a necessary process for complete removal of the remaining processed altered layer which has been still not removed by the etching before the growth on the crystal seed surface. The dissolution can be controlled by the temperature-elevating rate. Although the rate varies depending on the size of the autoclave and the number of the crystal seed, the best results can be obtained by performing the temperature elevation over the aforementioned period of 30 to 72 hours.

After the temperature elevation, the auto calve is maintained at a controlled temperature for a growth period necessary for obtaining a required crystal size and then cooled to the boiling point of water or lower, and a crystal is taken out. When an average temperature of the temperatures at controlling points is 80°C or lower, the autoclave can be safely opened. In order to suppress the change of the growth environment all over the growth period, it is particularly preferred to control the fluctuation range of the temperature difference within 5°C including the set value (desirably within the set value±2.5°C). The fluctuation range is preferably within 3°C (desirably within the set value±1.5°C) and further preferably within 1°C (desirably within the set value±0.5°C). Moreover, by using a material having a thermal conductivity at 400°C of 0.1 W/m·k or less as a heat retainer, it becomes possible to suppress the influence of temperature change of external environment to control the temperature within the above accuracy. The average temperature of the growth region and the raw material region is preferably 300 to 370°C, more preferably 310 to 360°C, and further preferably 315 to 350°C.

As above, by the etching of the crystal seed, the removal of the remaining processed altered layer during the temperature elevation, and the temperature control during the growth period, growth of the zinc oxide single crystal having no macro defects such as flowing can be achieved. The grown zinc oxide single crystal can be taken out from the crystal growth apparatus and processed by a method known by those skilled in the art.

According to the producing method of the invention, a zinc oxide single crystal having a low lithium concentration can be obtained without performing post-processes such as a heat treatment as is performed in a conventional technology. Therefore, an effect of a large cost reduction can be attained by shortening and simplifying the working steps. Moreover, alternation of the characteristics of the zinc oxide single crystal by the generation of point defects caused by the heat treatment and decrease in the yield ratio by the generation of cracks caused by the heat treatment can be avoided.

### Examples

The feature of the invention will be explained below in more detail by reference to Examples and Comparative Example. The materials, amounts, ratios, content of treatment, treating procedures, and the like shown in the following Examples can be appropriately changed unless they depart from the gist of the invention. Therefore, the scope of the invention should not be construed as being limited to the following specific examples.

### (Examples 1 to 21)

Using a single crystal growth apparatus having a structure shown in Fig. 1, a zinc oxide single crystal was produced. As a crystal seed, there was used a plate-like crystal having a thickness of 1.0 mm and an etch pit density of 1×10² to 1×10⁴/cm² where C plane is a principal plane and a major diameter is 20 mm. The conditions described in Table 1 were adopted in each of Examples 1 to 21. The LiOH concentration in the solution described in Table 1 is represented as a ppm unit (weight basis) only in Example 21.
A temperature change during the crystal growth of zinc oxide was measured by monitoring with a thermocouple and described in Table 1. Moreover, a pressure change during the crystal growth of zinc oxide was measured by monitoring with a pressure gauge and described in Table 1.
In Examples 1, 3 to 9, 12, and 15 to 21 macro defects such as flowing were not observed at all in the resulting zinc oxide single crystals and thus they exhibit an extremely high quality. Moreover, it was confirmed that the group of Examples 2 and 10, then Example 11, and then the group of Examples 13 and 14 were preferred in that order.
The lithium concentration and aluminum concentration in the resulting zinc oxide single crystals are measured by secondary ion mass spectrometry and the results were described in Table 1. As a measuring apparatus, a 4F type secondary ion mass spectrometer manufactured by Cameca was employed. Using an O₂⁺ ion as a primary ion species, primary ion energy was set at 8 keV. In this regard, a detection limit of lithium in this method is 5×10¹³ atoms/cm³, and a detection limit of aluminum is 5×10¹³ atoms/cm³.
When the nitrogen concentration in the zinc oxide single crystals obtained in Examples 6 and 8 was measured by secondary ion mass spectrometry, the concentration was not more than 2×10¹⁶ atoms/cm³ that is a detection limit, in both cases. As a measuring apparatus, a 4F type secondary ion mass spectrometer manufactured by Cameca was employed. Using a Cs⁺ ion as a primary ion species, primary ion energy was set at 14.5 keV.
A half width was determined by X-ray locking curve measurement in (0002) plane of the resulting zinc oxide single crystals and the results were described in Table 1. As a measuring apparatus, Rigaku ATX-E was employed and, as an optical system, 4 crystal Ge (440) monochromator was used. The slit size is 1×10 mm.

### (Comparative Example 1)

Using the same crystal seed and crystal growth apparatus as in Examples 1 to 21, zinc oxide was grown into a crystal in the same manner under the conditions in Table 1. As a result, the lithium concentration of the resulting zinc oxide single crystal was 6.5×10¹⁷ atoms/cm³, and the aluminum concentration was 1.0×10¹⁵ atoms/cm³. Macro defects such as flowing were not observed in the crystal.
The resulting zinc oxide single crystal was subjected to a heat treatment at 1400°C for 2 hours. As a result, the lithium concentration of the zinc oxide single crystal became 9×10¹⁴ atoms/cm³ as described in Table 1.

**[Table 1]**

| | Crystal growth conditions | | | | | | | | | | Evaluation of single crystal | | |
|---|---|---|---|---|---|---|---|---|---|---|---|---|---|
| | KOH concentration in solution (mol/L) | LIOH concentration in solution (mol/L) | Average temperature (°C) | Temperature difference between growth region and raw material region (°C) | Temperature change (°C/day) | Pressure (MPa) | Pressure change (MPa/day) | Growth time (day) | C axis growth rate (mm/day) | With or without annealing | Li concentration in crystal l(atoms/cm³) | Al concentration in crystal (atoms/cm³) | Half width of X-ray locking curve (arcsec) |
| Example 1 | 3 | 0 | 315 | 30 | ±0.5 or less | 96 | ±1 or less | 2 | 0.39 | No | 9.3×10¹³ | 5×10¹³ or less | 19 |
| Example 2 | 3 | 0 | 330 | 30 | ±0.5 or less | 117 | ±1 or less | 7 | 0.51 | No | 5×10¹³ or less | 5×10¹³ or less | 20 |
| Example 3 | 3 | 0 | 315 | 20 | ±0.5 or less | 120 | ±1 or less | 25.5 | 0.23 | No | 5×10¹³ or less | 5×10¹³ or less | 18 |
| Example 4 | 3 | 0 | 315 | 26 | ±0.5 or less | 118 | ±1 or less | 25.5 | 0.23 | No | 5×10¹³ or less | 5×10¹³ or less | 18 |
| Example 5 | 4 | 0 | 326.5 | 13 | ±0.5 or less | 96 | ±1 or less | 16.8 | 0.24 | No | 1.8x10¹⁴ | 5×10¹³ or less | 18 |
| Example 6 | 3.75 | 0 | 326.5 | 13 | ±0.5 or less | 80 | ±1 or less | 23.7 | 0.19 | No | 5×10¹³ or less | 5.8×10¹³ | 18 |
| Example 7 | 3.75 | 0 | 326.5 | 13 | ±0.5 or less | 58 | ±1 or less | 29.9 | 0.200 | No | 5×10¹³ or less | 5.1×10¹³ | 18 |
| Example 8 | 3.85 | 0 | 327 | 14 | ±0.5 or less | 77 | ±1 or less | 52.7 | 0.185 | No | 5×10¹³ or less | 1.2×10¹⁴ | 18 |
| Example 9 | 3.85 | 0 | 341 | 12 | ±0.5 or less | 83 | ±1 or less | 14.7 | 0.249 | No | 5×10¹³ or less | 5×10¹³ or less | 18 |
| Example 10 | 3.85 | 0 | 351 | 12 | ±0.5 or less | 82 | ±1 or less | 16.7 | 0.254 | No | 5×10¹³ or less | 7.0×10¹³ | 18 |
| Example 11 | 3.85 | 0 | 361 | 12 | ±0.5 or less | 85 | ±1 or less | 14.7 | 0.302 | No | 5×10¹³ or less | 5×10¹³ or less | 18 |
| Example 12 | 4.25 | 0 | 349.5 | 10 | ±0.5 or less | 81 | ±1 or less | 16.7 | 0.25 | No | 5×10¹³ or less | 7.3×10¹³ | 18 |
| Example 13 | 3.85 | 0 | 371 | 12 | ±0.5 or less | 79 | ±1 or less | 25.6 | 0.24 | No | 5×10¹³ of less | 8.4×10¹³ | 22 |
| Example 14 | 3.25 | 0 | 349.5 | 10 | ±3 | 80 | ±1 or less | 16.6 | 0.21 | No | 5×10¹³ or less | 6.7×10¹³ | 20 |
| Example 15 | 4.5 | 0 | 349.5 | 10 | ±0.5 or less | 83 | ±1 or less | 16.7 | 0.241 | No | 5×10¹³ or less | 8.0×10¹³ | 18 |
| Example 16 | 4.5 | 0 | 348.75 | 9 | ±0.5 or less | 80 | ±1 or less | 37.7 | 0.160 | No | 5×10¹³ or less | 5×10¹³ or less | 18 |
| Example 17 | 4.5 | 0 | 348.75 | 9 | ±0.5 or less | 81 | ±1 or less | 16.7 | 0.242 | No | 5×10¹³ or less | 6.3×10¹³ | 18 |
| Example 18 | 4.5 | 0 | 348.75 | 9 | ±0.5 or less | 82 | ±1 or less | 17.0 | 0.207 | No | 5×10¹³ or less | 7.7×10¹³ | 18 |
| Example 19 | 5.0 | 0 | 343.75 | 9 | ±0.5 or less | 74 | ±1 or less | 17.0 | 0.211 | No | 5×10¹³ or less | 7.3×10¹³ | 18 |
| Example 20 | 4.75 | 0 | 343.75 | 9 | ±0.5 or less | 69 | ±1 or less | 31.0 | 0.183 | No | 5x10¹³ or less | 6.4×10¹³ | 18 |
| Example 21 | 3.5 | 1.0 ppm | 330 | 12 | ±0.5 or less | 83 | ±1 or less | 28 | 0.122 | No | 3.4×10¹⁴ | 2.1×10¹⁴ | 20 |
| Comparativ e Example 1 | 3 | 1 | 335 | 50 | ±0.5 or less | 80 | ±1 or less | 60 | 0.20 | Yes | 9.0×10¹⁴ (after annealing) 6.5×10¹⁷ (before annealing) | 1.0×10¹⁵ (before annealing) | 18 |

### (Examples 22 to 26)

Using the same crystal seed and crystal growth apparatus as in Examples 1 to 21, zinc oxide was grown into a crystal in the same manner under the conditions in Table 2. Examples 22, 24, and 26 are crystals grown on (0001) plane [+C plane] and Examples 23 and 25 are crystals grown on (000-1) plane [-C plane]. In Examples 22 to 25, two sheets of wafers were cut out each from the identical crystal and evaluated. The carrier concentration, mobility, and specific resistance of the resulting zinc oxide single crystal were determined by Hall measurement (van der Pauw method). As a measuring apparatus, ResiTest 8300 manufactured by Toyo Corporation was employed. Macro defects such as flowing were not observed at all in the resulting zinc oxide single crystal and the crystal had an extremely high quality.

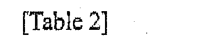

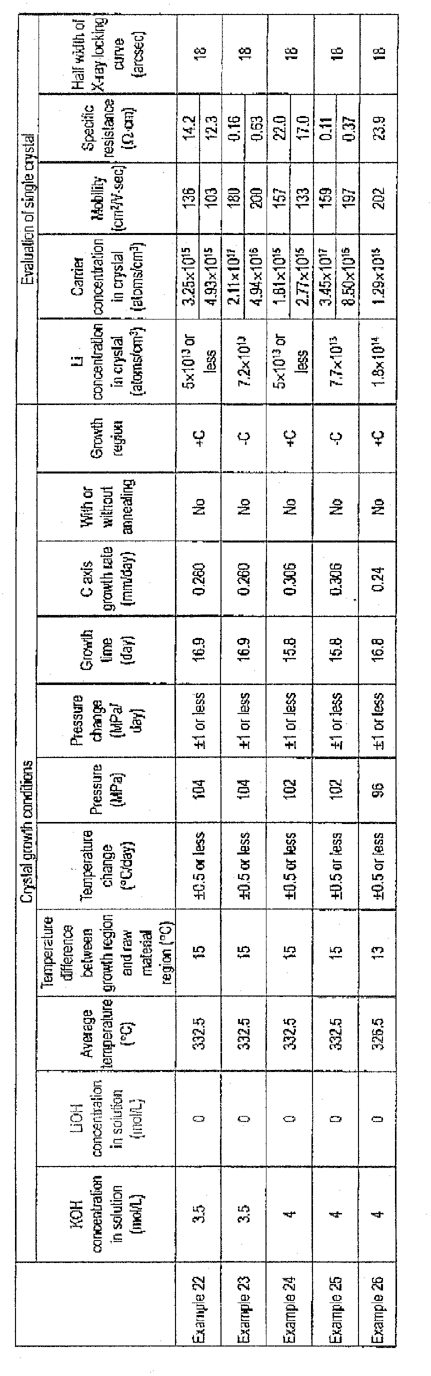

### (Example 27-30)

Using the same crystal seed and crystal growth apparatus as in Examples 1 to 21, zinc oxide was grown into a crystal in the same manner under the conditions in Table 3 with adding gallium oxide (Ga₂O₃) into the raw material. The Ga concentration shown in Table 3 is concentration as Ga element (weight basis) in the raw material. Examples 27 and 29 are crystals grown on (0001) plane [+C plane] and Examples 28 and 30 are crystals grown on (000-1) plane [-C plane]. The gallium concentration of the resulting zinc oxide single crystal was measured by secondary ion mass spectrometry. As a measuring apparatus, a 4F type secondary ion mass spectrometer manufactured by Cameca was employed. Using an O₂⁺ ion as a primary ion species, primary ion energy was set at 8 keV. In this regard, a detection limit of gallium in this method is 5×10¹⁴ atoms/cm³. Moreover, the specific resistance of the resulting zinc oxide single crystal was measured by an eddy current method using a noncontact resistivity meter (Model 1510A manufactured by Lehighton Electronics Inc.). Macro defects such as flowing were not observed at all in the resulting zinc oxide single crystal and the crystal had an extremely high quality.

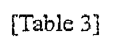

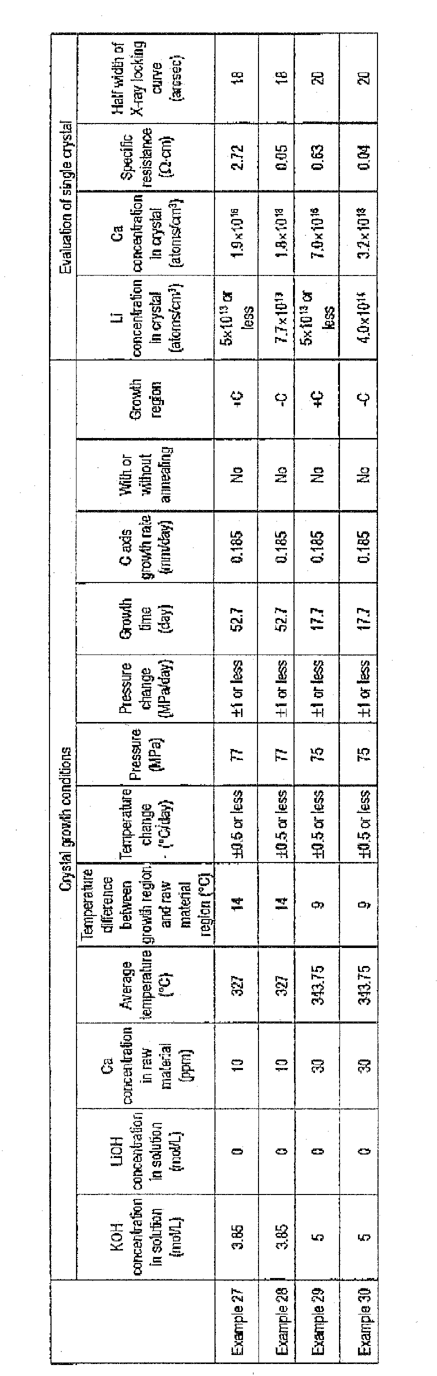

While the invention has been described in detail and with reference to specific embodiments thereof, it will be apparent to one skilled in the art that various changes and modifications can be made therein without departing from the spirit and scope thereof.
The present application is based on Japanese Patent Application No. 2008-097825 filed on April 4, 2008, Japanese Patent Application No. 2008-199126 filed on August 1, 2008, and Japanese Patent Application No. 2009-069280 filed on March 23, 2009, and the contents are incorporated herein by reference.

### Industrial Applicability

According to the producing method of the present invention, a zinc oxide single crystal having a sufficiently low lithium concentration and a high crystallinity can be stably and conveniently produced in a high yield ratio. Moreover, since the producing method of the invention is also suitable for mass production, the method has a high industrial applicability. Furthermore, the zinc oxide single crystal of the invention exhibits a wide application range and, for example, when it is used as a substrate for epitaxial growth, it becomes possible to produce an epitaxial film free from contamination with lithium since diffusion of lithium from the substrate into the epitaxial film does not occur. In addition, the zinc oxide single crystal can be applied to light-emitting devices including LED and semiconductor devices such as solar cell. Accordingly, the invention has an extremely high industrial applicability.

## Claims

1. A zinc oxide single crystal wherein the lithium concentration in the crystal is 5×10¹⁴ atoms/cm³ or less.

2. The zinc oxide single crystal according to claim 1, wherein a half width determined by X-ray locking curve measurement in (0002) plane reflection is 50 seconds or less.

3. The zinc oxide single crystal according to claim 1 or 2, wherein the principal plane is C plane, M plane, R plane, Rp plane, or Rn plane.

4. The zinc oxide single crystal according to any one of claims 1 to 3, wherein the nitrogen content in the crystal is 1×10¹⁸ atoms/cm³ or less.

5. The zinc oxide single crystal according to any one of claims 1 to 4, wherein the aluminum concentration in the crystal is 2×10¹⁴ atoms/cm³ or less.

6. The zinc oxide single crystal according to any one of claims 1 to 5, wherein the major diameter is 15 mm or more.

7. The zinc oxide single crystal according to any one of claims 1 to 6, wherein the carrier concentration at room temperature is 1×10¹⁴ to 1×10¹⁸ atoms/cm³.

8. The zinc oxide single crystal according to any one of claims 1 to 7, wherein the mobility at room temperature is more than 100 cm²/V·sec and 300 cm²/V·sec or less.

9. The zinc oxide single crystal according to any one of claims 1 to 8, wherein the specific resistance is 1×10⁻³ to 1×10³ (Ω·cm).

10. The zinc oxide single crystal according to any one of claims 1 to 9, wherein the crystal contains one kind or two or more kinds of trivalent metal elements and the content thereof is 1×10¹⁶ to 1×10²⁰ atoms/cm³.

11. The zinc oxide single crystal according to any one or claims 1 to 10, which is produced by hydrothermal synthesis method.

12. A method for producing a zinc oxide single crystal which comprises growing a zinc oxide crystal by hydrothermal synthesis method using a solution having a lithium concentration of 1 ppm or less (weight basis) at a temperature within the range of 300 to 370°C.

13. A method for producing a zinc oxide single crystal which comprises growing a zinc oxide crystal using a solution having a lithium concentration of 1 ppm or less (weight basis) by hydrothermal synthesis method, while suppressing a fluctuation range of crystal growth temperature within 5°C at the growth of the zinc oxide crystal.

14. The method for producing a zinc oxide single crystal according to claim 12 or 13, wherein the solution does not contain lithium.

15. The method for producing a zinc oxide single crystal according to any one of claims 12 to 14, wherein the solution does not contain an ammonium ion.

16. The method for producing a zinc oxide single crystal according to any one of claims 12 to 15, wherein a raw material having a lithium concentration of 0.1 ppm or less (weight basis) is employed.

17. The method for producing a zinc oxide single crystal according to any one of claims 12 to 16, wherein a zinc oxide crystal is grown in a reaction container having an inner wall that uses an alloy containing platinum and one kind or more of elements of the platinum group other than platinum.

18. The method for producing a zinc oxide single crystal according to claim 17, wherein an alloy containing 5 to 30% by weight of the elements of the platinum group other than platinum is employed.

19. The method for producing a zinc oxide single crystal according to claim 17 or 18, wherein the element of the platinum group other than platinum is iridium.

20. The method for producing a zinc oxide single crystal according to any one of claims 12 to 19, wherein a zinc oxide crystal is grown in a reaction container having a pressure-buffering mechanism provided in a raw material-dissolution region.

21. A zinc oxide single crystal produced by the producing method according to any one of claims 12 to 20.
